# EUROPEAN PATENT APPLICATION

(11) **EP 4 498 416 A1**
(43) Date of publication of application: **29.01.2025**
(21) Application number: 23187688.9
(22) Date of filing: 25.07.2023
(51) Int. Cl.: H01L 21/683, H01L 23/00, H01L 23/544

(54) **DIE TRANSFER METHOD, LOADED DIE TRANSFER CARRIER, AND USE THEROF**

(71) Applicant: Nederlandse Organisatie voor toegepast-natuurwetenschappelijk Onderzoek TNO, 2595 DA 's-Gravenhage (NL)
(72) Inventor: ARUTINOV, Gari, 2595 DA 's-Gravenhage (NL); BURGHOORN, Maria Mathea Antonetta, 2595 DA 's-Gravenhage (NL)
(74) Representative: V.O.

(57) **Abstract**

There is provided A method (100) of redistributing singulated dies (1), the method comprising: providing (110) a donor substrate (10)] comprising a dicing foil (11) supporting an array (A) of said dies, and providing (111) an acceptor substrate (20) comprising a carrier substrate (21) with a cover layer (25) of a photocurable adhesive composition (26); assembling (120) the dicing foil onto the acceptor substrate forming a stack (30) having the singulated dies sandwiched between the dicing foil and the cover layer of the photocurable adhesive composition; photocuring (130) the photocurable adhesive composition at dicing streets (2) between adjacent ones of the singulated dies by providing a photonic exposure (PE) from a dicing foil side (31) of the stack; developing (140) the cover layer of the photocurable adhesive composition by thermal exposure; and releasing (150) the dicing foil from the stack.

## Description

### TECHNICAL FIELD AND BACKGROUND

The present disclosure relates to a method of transferring an array of singulated dies. Specifically, redistributing from a donor to a target substrate. The present disclosure further relates to a die transfer carrier loaded with dies for redistribution.

In the semiconductor industry it is common to receive a wafer with an array of singulated (diced) dies on a release foil, UV or thermal. These components are typically transferred, e.g. by pick and place method, in accordance with a circuit design.

Mass transfer methods enabling high spatial density and precision are highly relevant in the manufacturing of microelectronic devices, e.g. kin the manufacturing of displays based on microLEDs. Moreover, to increase the yield a selective transfer is a desired. For example, to place missing components and allow repair.

Although direct transfer from an epitaxial (aka epi) wafer is also possible with specific laser sources, these processes tend to require improvement in terms of reducing release of undesired debris and/or residues with transfer, and/or in terms of transfer precision.

It is known to transfer dies with the aid of an intermediate step of transferring an array of dies to an intermediate carrier. For example, a dicing tape or a specific transfer carrier. Undesired drift of regularly placed microcomponents can replicated during the final laser die to transfer to a target substrate.

Depending on a Laser Die Transfer strategy deployed and the release method used, the die redistribution step might differ, but overall the process typically starts with transferring dies, e.g. µLEDs grown on an epitaxial wafer, to a laser-transparent carrier which has a sacrificial layer (Dynamic Release Layer, DRL) on its surface. This transfer is often done using an intermediate transfer tape to ensure that the dies end up oriented on the DRL carrier active side away from the glass substrate, ready for flip-chip assembly. Alternatively for face-up integration (chip first approach) the intermediate step might be skipped.

WO2022/186689 discloses a laser die release from an intermediate carrier loaded with dies. The intermediate carrier includes a multilayer stack that is composed of three functional layers. A light-absorbing metal layer that has a high melting temperature, a melt layer melting temperature lower than the light-absorbing metal layer, and a polymeric adhesive with a decomposition temperature that is closely matched with the melting temperature of the metal melt layer.

Accuracy of die placement using intermediate transfer solutions is limited by accuracy at which dies are provided onto these transfer carriers.

### SUMMARY

While the process using intermediate transfer tapes/carries as taught in WO2022/186689 offers specific benefits there a need to improve overall transfer performance while retaining specific benefits. Specifically, the present disclosure aims to mitigate even minor issues in the positional accuracy due to loading and/or thermal treatment of the intermediate carriers.

Aspects of the present disclosure relate to a die transfer method. Specifically, the method provides a transfer of dies from a source comprising a plurality of singulated dies to a target. The source can be a dicing foil supporting an array of said dies or a other carrier such as a carrier comprising as grown dies (e.g. an epi-wafer), e.g. as received from a production fab. In some embodiments, the target once loaded with dies can be an intermediate transfer substrate from which the dies in the array can be redistributed, e.g. individually, as a subset, or as part of the array or even as an array. Alternatively the target substrate can be a part of the final product.

The method as disclosed herein comprises at least the processes of i) providing a donor substrate which comprises or consists of a donor carrier (e.g.) a dicing foil, supporting an array of singulated dies, and providing an acceptor substrate comprising a carrier substrate with a cover layer of a photocurable adhesive composition. The photocurable adhesive composition can advantageously be a commercially based composition.

Advantageously, the method as disclosed herein enables fast, reliable and accurate transfer of the array of dies to the target substrate, whereby relative positioning of the dies, e.g. spacing and relative orientation, can remain unchanged.

The donor substrate can advantageously be a dicing or transfer foil as commonly available, e.g. a dicing foil having mounted thereon an array of individualized dies (diced dies, e.g. sawn) . Alternatively, or in addition, the source can be a carrier supporting an array of components formed or grown thereon. For example, a so-called EPI wafer comprising a plurality of microelectronic components or dies formed thereon.

The method further comprises ii) assembling the donor including the array onto the acceptor substrate forming a stack whereby the singulated dies are sandwiched between the donor substrate and the cover layer of the photocurable adhesive composition. Because during the contacting the dies are adhered to the donor (e.g. dicing foil) a shift or loss of relative orientation can be mitigated. In some embodiments, the contacting can be performed in a lamination device, e.g. under application a contact pressure. Alternatively, or in addition, heat may be applied prior to and/or during contacting to increase a tack of the adhesive cover layer. Yet further, in some embodiments, the method may comprise a provision to reduce an initial adhesion force between the donor and the dies (e.g. to about 10% of an initial adhesion). For example, depending on a type of the donor (e.g. a thermal release or UV photo release foil) the provision may include an exposure to appropriate heat and/or light. Similarly, the acceptor substrate may be treated to increase an initial tack of the photocurable adhesive composition, e.g. a soft bake procedure. Reducing an initial adhesion between donor and die, and/or increasing an initial tack of the photocurable adhesive composition, especially when combined, can increase an accuracy (fidelity) of transferring the array. It will be understood that the provisions to reduce the initial adhesion and/or to increase the tack can be performed as individual steps prior to the assembling. Alternatively, or in addition, one or more of the provision may be, during the assembling.

The method further comprises iii) photocuring the photocurable adhesive composition at spacings (e.g. dicing streets) between adjacent ones of the singulated dies by providing a photonic exposure from a donor side of the stack. Depending on the type of photocurable adhesive composition, especially on a photo initiator comprised therein, the exposure typically involves a UV exposure. It will be understood that the donor substrate will be transparent or at least translucent to light at a frequency range including an activation energy of the photo initiator comprised in the photocurable adhesive. Preferably, the donor transmits at least 10% of the light at the relevant frequency, preferably more, e.g. at least 20%, more preferably at least 50%, even more preferably 50% or even more, e.g. 60%, 70%, 80% or even 90% or more.

Advantageously many commercial dicing foils are available that are at least partially transparent over a relevant photocuring bandwidth. By exposing the cover layer though the dicing foil the dies advantageously serve as masks that prevent exposure of the photocurable adhesive composition underlying the die. Accordingly, the photocuring can be limited to zones of the cover layer that correspond to the spacings between dies.

In some embodiments, the method comprises one or more chip transfer stages. These steps can be performed in case when one, or more prior flips of the components are desired or in case the components are provided or received on substrate having insufficient transparency at the relevant UV range for photocuring the photocurable adhesive. As will be detailed herein below these transfer steps can be performed using one or more commercially available transfer substrates/tapes, e.g. UV and/or thermal transfer carriers. Regardless whether or not intermediate transfer stages are employed, the method typically further comprises a process referred to as iv) developing (140) the coverlayer of the photocurable adhesive composition by application of heat. The developing results in thermal initiated curing and/or progression of the crosslinking process of the photocurable adhesive as initiated by the photonic exposure composition, also at portions that were not directly exposed to light. To maximize crosslinking efficiency, the developing is preferably applied following, preferably directly following, or even in part during the photocuring. To minimize a thermal load on the dies the heat is preferably preferentially or even exclusively provided via a bottom face of the stack, e.g. from a bottom side of the carrier substrate 21 opposite the cover layer 25. For example, via a heated bottom plate of a press laminator.

After developing, the process further comprises v) releasing the dicing foil from the stack. The release may comprise a peel-off, e.g. a manual peel off, or an automated release. For example, with a clamp (e.g. vacuum clamp). If needed an adhesion between the dies and the donor (e.g. dicing foil or transfer carrier) can be pre-reduced (e.g. down to about zero) by one or more of the provisions (e.g. thermal/UV) mentioned above.

Optionally, the processing of thermal crosslinking and/or foil release may be delayed, e.g. performed externally. As such the stack may be considered an intermediate product, for later usage as disclosed herein, e.g. in the manufacturing of microLED displays.

As will be further clarified in de description below the method as disclosed herein advantageously mitigates issues with positional accuracy during and/or thermal treatment, while being compatible with industry standards such as thermal and UV release/dicing tapes. Specifically, inventors found that the preliminary photo curing of the adhesive cover layer that is restricted to zones in correspondence with the spacings/dicing streets between dies mitigates displacement /drift of dies during subsequent stages, particularly the development. Inventors find that the photocured spacings between dies (e.g. dicing streets) act as rigid barriers that physically restrict or eliminate flow/drift of dies on softened or even molten non-exposed zones of the photocurable adhesive composition during the thermal curing (e.g. hard bake).

In some embodiments, releasing the dicing foil can be performed at least in part during the process of developing the photocurable adhesive composition. Inventors found that heat provided during thermal curing can advantageously reduce adhesion between dies and the donor foil. Depending on the type of donor foil, added heat can at least partly reduce adhesive of the dies with respect the donor foil, especially for thermal release-based donors (e.g. thermal release dicing foils/ thermal release tape).

To maximize a spatial stability of dies in the array during transfer the donor substrate (e.g. dicing foil) is preferably removed (e.g. peeled off from the stack after full development (hard bake) of the photocurable adhesive layer.

In some preferred embodiments, the method comprises soft baking the cover layer of the photocurable adhesive composition prior to the assembling. Soft baking can increase a viscosity and/or initial tack of the photocurable adhesive composition, e.g. by removing a substantial fraction, a majority, or even essentially all of an initial content of volatiles (e.g. solvent) comprised in the cover layer as provided.

In other or further preferred embodiments, the method further comprises reducing an adhesion between the singulated dies and the donor. For example, by providing a photonic exposure from a back side of the donor substrate opposite the dies prior to and/or during the assembling.

In some preferred embodiments, the acceptor comprises a release stack disposed onto the carrier substrate, said release stack being configured for releasing one or more of the dies as transferred thereon from to a target substrate following an illumination of the release stack by a light beam (L) through the carrier substrate, wherein the release stack comprises
- a melt layer having a melting temperature,
- a light-absorbing layer disposed between the carrier substrate and the melt layer, wherein the light-absorbing layer has an absorption coefficient for absorbing the light beam thereby causing the light-absorbing layer to be heated, wherein the heated light-absorbing layer is in thermal contact with the melt layer for conducting its heat to the melt layer thereby causing a temperature of the melt layer to rise above its melting temperature, wherein the light-absorbing layer has a melting temperature which is higher than the melting temperature of the melt layer such that the light-absorbing layer can remain solid while the melt layer is melted by the heat conducted from the light-absorbing layer, and
- the cover layer of the photocurable adhesive composition covering the melt layer, wherein
a temperature during transferring the array of singulated dies from the donor to the acceptor remains below the melting temperature of the melt layer. For details as to the dynamic release stack, including but not limited to the composition and properties of the melt layer, the light-adsorbing layer, geometric modifications thereof, and its application in redistribution to target substrates (e.g. circuit boards), reference is made to WO2022/186689 which his hereby incorporated by reference.

According to a further aspect there is provided a loaded die transfer carrier. In some variations the die transfer carrier can be understood as the acceptor substrate, as disclosed herein, loaded with an array of dies according to the method as disclosed herein. The die transfer carrier comprising carrier substrate having a cover layer formed of a photocurable adhesive composition and an array of singulated dies, wherein first portions of the photocurable adhesive composition corresponding to areas underlying separations between adjacent ones of the singulated dies are photocured.

In a preferred variation the die transfer carrier comprises the release stack (melt-layer/light-sorbing layer/cover layer) as disclosed herein.

Depending on a use case portions of the cover layer underlying the dies may be uncured. Typically, the cover layer is in a cured state (e.g. by developing) prior to use, e.g. in die redistribution. The use comprises at least a process of redistributing one or more of the dies as transferred onto the acceptor substrate to a target location on product carrier, e.g. a circuit board. For example, by locally triggering the release stack, e.g. with laser or masked illumination.

### BRIEF DESCRIPTION OF DRAWINGS

These and other features, aspects, and advantages of the apparatus, systems and methods of the present disclosure will become better understood from the following description, appended claims, and accompanying drawing wherein:
FIG 1 schematically illustrates a method 100 of redistributing singulated dies 1;
FIGs 2A through 2I illustrate various aspects and features of the method at various stages of progress;
FIG 3; schematically illustrates a loaded die transfer carrier 200;
FIG 4A illustrates an loaded die transfer carrier 200;
FIG 4B illustrates an loaded transfer carrier 200 during use;
FIG 4C illustrates a variation of loaded die transfer carrier 200;
FIGs 5A to 5E illustrate aspects of a method;
FIGs 6A and 6B provide experimental details; and
FIG 7 provides further experimental details.

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise. It will be further understood that the terms "consisting essentially of' and "essentially consists of', as used herein with reference to materials (e.g. metal, semi-conductor, polymer), means that further components may present insofar as these do not materially affect the essential characteristics of the compound or composition. Alternatively, or additionally, these term can be used to signify a majority constituent, e.g. with a mass percentage >90%, >95%, >99, >99.9% or 100% (or simply "consists of').

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

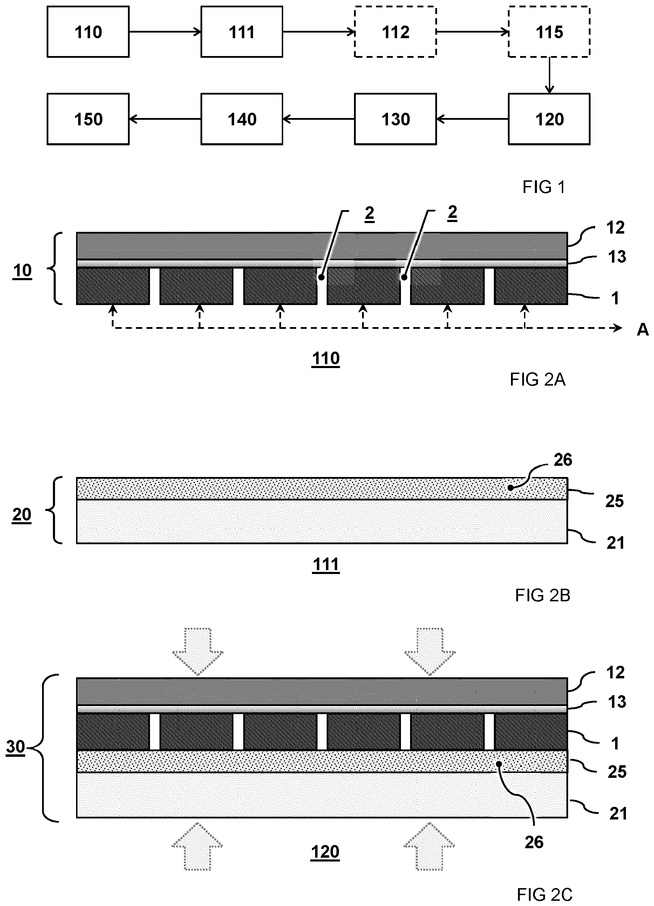

FIG 1 provides a schematic view of an embodied of the method 100 of redistributing singulated dies as disclosed herein. The method comprises at least the process steps of; providing 110 a donor substrate supporting an array of said dies, and providing an acceptor substrate comprising a carrier substrate with a cover layer of a photocurable adhesive composition; assembling 120 the donor onto the acceptor substrate forming a stack having the singulated dies sandwiched between the donor and the cover layer of the photocurable adhesive composition; photocuring 130 the photocurable adhesive composition at spacings between adjacent ones of the singulated dies by providing a photonic exposure from a back side of the donor; developing 140 the coverlayer of the photocurable adhesive composition by thermal exposure; and releasing 150 the donor substrate from the stack. In some embodiments, e.g. as shown, the method further comprises one or more of:
- soft baking 115 the cover layer of the photocurable adhesive composition prior to the assembling, and
- reducing 112 an adhesion between the singulated dies and the donor,
wherein the soft baking and/or the reducing 112 the adhesion by be provided prior to and/or combined with the process of the assembling 120.

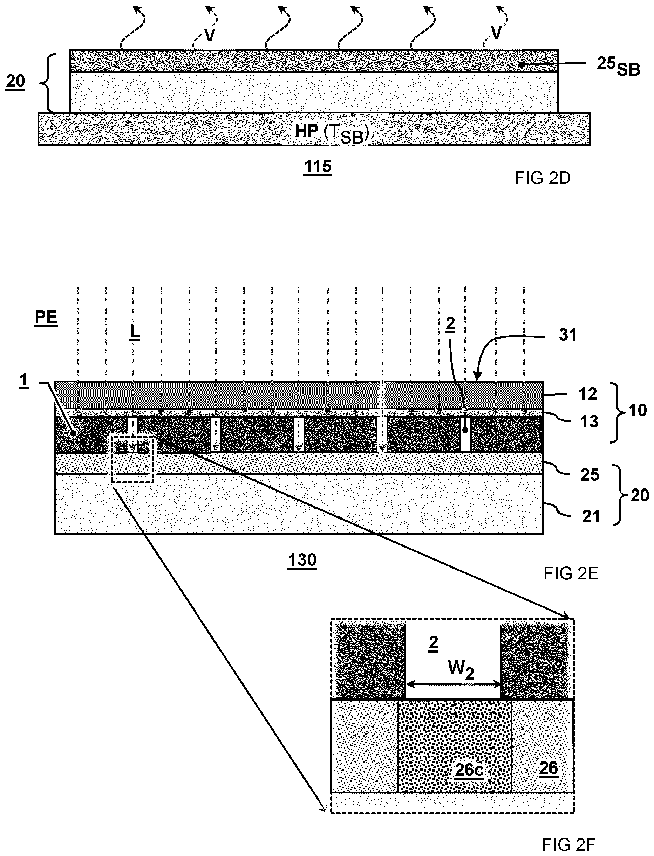

FIG 2A provides a cross-section side view of a donor substrate 10 as provided 110 for further processing in the method. The donor substrate 10 comprises a substrate 12 supporting a plurality of singulated die 1. The donor is transparent to UV light. From hereon the example will be detailed as if the donor is a dicing foil. The die are arranged in an array A (e.g. a 2D array) 10. The substrate can be a dicing foil as obtained from a fab. A separation (w2, see FIG 2F) between the die in the array can, what is commonly referred to as a dicing street, which. e.g. depending of a width of a sawing blade used for dicing, can be ≤ 100 pm, e.g. about 50, 60 or 70µm or less. To facilitate adhesion/release of the dies to the dicing foil typically comprises a dynamic release layer 13 (DRL). As known in the field the dicing foil may be a thermal or UV release foil.

FIG 2B provides a cross-section side view of an acceptor substrate 20. The acceptor substrate 20 comprises at least a carrier substrate 21 and a cover layer 25. A dimension of the acceptor substrate 20 can depend on a number or dimension of the dies to be transferred thereto. Typically, the acceptor substrate 20 is configured to receive the entire array A of dies from the dicing foil. The cover layer 25 can advantageously be comprised of an adhesive composition 26, e.g. without additional layers as shown. The photocurable adhesive composition 26 can be a commercial composition and can be a negative photo resist composition, e.g. an epoxy based negative photo resist such as an SU8-based resist. To allow photo curing of the resist the carrier substrate is at least partially transmissive to light over a bandwidth covering activation of the photoresist.

FIG 2C provides a schematic cross-section sideview of the donor substrate 10 and the acceptor substrate 20 assembled on top of each other to form a stack 30. The stack comprises (in order from top to down as illustrated): the donor substrate 10 (carrier 21 and DRL 13), an array of singulated dies 1, the cover layer 25, and the carrier substrate 21.

To improve a contact between a top face of the cover layer 25 opposite the carrier substrate 21 and a top face of the die opposite the dicing foil a contact pressure is can be applied as indicated by the dotted arrows. For example, by placing the stack in a laminating press. To prevent shift of dies the contact force can be maintained during the subsequent stage of photocuring 130, which will be explained in more detail with reference to FIG 2E and 2F.

In some embodiments, e.g. as illustrated in FIG 2D, the stacking may be preceded by a stage of soft baking 115 the cover layer 25. As known in the field a soft bake, e.g. of SU8, may be understood as a thermal treatment configured to remove (evaporate) a majority of a volatiles content, e.g. solvent, in the layer, without causing curing of the layer, e.g. below a thermal curing temperature of the photocurable adhesive composition 26. The soft bake can increase a tack of the cover layer 25 and or a structural rigidity, e.g. reducing contact force induced compressing of the cover layer 25. As indicated the heat for reaching a soft bake temperature (T_{SB}) can be conveniently supplied by a hotplate (HP), e.g. a heated bottom plate of the lamination press.

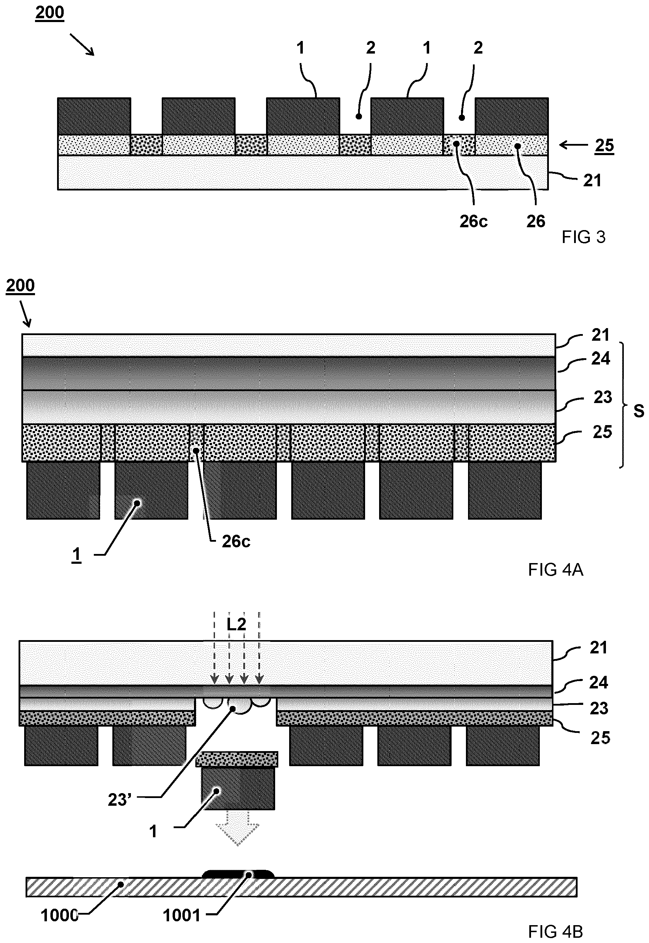

FIG 2E provides a cross-section side view of the stack during photocuring 130 the photocurable adhesive composition at dicing streets 2 between adjacent ones of the singulated dies 1 by providing a photonic exposure PE from a dicing foil side 31 of the stack. As shown light L can pass through dicing foil 12,13. As best seen with further reference to the partial detail view in FIG 2F, only those zones of the cover layer 25 that are not masked by the dies are exposed to the light yielding locally photocured portions 26c (see FIG 3C). The light for the initial photo cure can be conveniently provided using known methods, e.g. UV sources. Advantageously the PE can be provided during application of a contact pressure onto the stack, e.g. via a transparent window or aperture provided in a top plate of the lamination press.

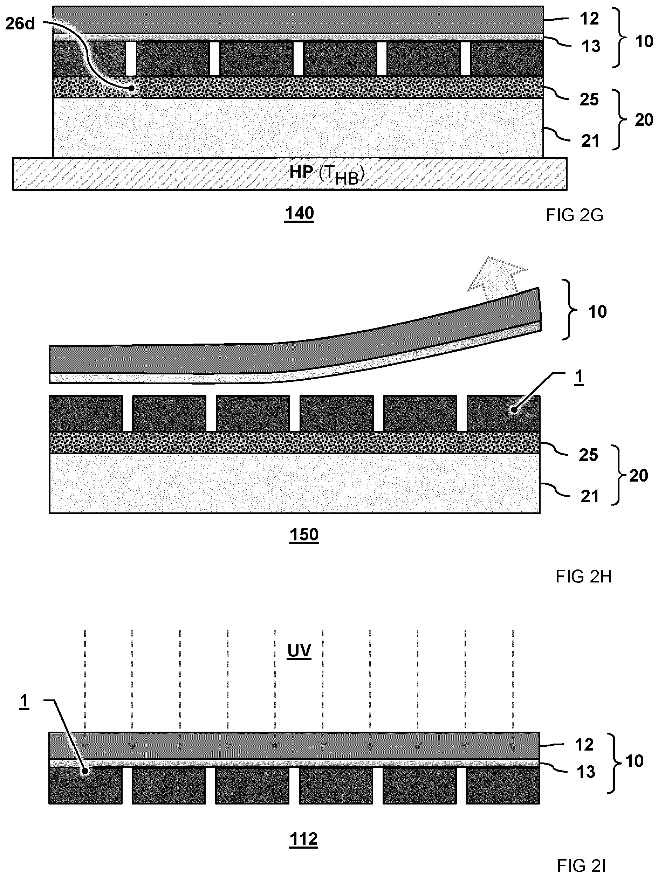

FIG 2G provides a cross section-side view of the stack during a process of developing 140 the cover layer 25. In some embodiments, e.g. as shown, the heat for thermal curing of can be provided via a bottom side of the stack. For example, the same hot plate as mentioned with respect to FIG 2D. Providing the heat for curing from a bottom side, e.g. a bottom plate of the lamination press, reduces a thermal load/exposure of the singulated dies 1.

FIG 2H provides a cross section-side view of the stack during a releasing 150 the dicing foil. In one embodiment, e.g. as shown, the foil can be peeled off as indicated by the doted arrow.

FIG 2I illustrates reducing 112 an adhesion between the singulated dies 10 and the dicing foil 12,13 by providing a UV exposure from a back side of the dicing foil opposite the dies.

FIG 3 provides a cross section side view of an intermediate die transfer carrier 200. The die transfer carrier can be a product of the method directly following the stage of photocuring 130 dice streets but before hard bake / full curing.

In some embodiments the donor (dicing foil) 11,12 can be removed e.g. by peeling in combination with a thermal of light induced reduction of adhesion. In other variations the intermediate die transfer carrier 200 may be manufactured with the donor still in place, e.g. for developing 140 at a later stage, for example at an different site. Of course cover layer 25 of the intermediate die transfer carrier 200 can be cured.

Note that the dies can remain in place throughout the entire transfer process due to the provision of photocured dicing streets, in combination with a shift of adhesion from the dicing foil to the cover layer 25 by the thermal curing, optionally in combination with reducing 112 an adhesion between the singulated dies and the dicing foil.

FIG 4A provides a cross-section side view of a variation wherein the intermediate die transfer carrier 200 comprises a release stack S. The cover layer 25 is cured throughout by subsequent photo curing the trenches between the dies and hard baking during/following removal of the donor substrate.

The release stack comprises a melt layer 23 having a melting temperature, a light-absorbing layer 24 disposed between the carrier substrate and the melt layer, wherein the light-absorbing layer has an absorption coefficient for absorbing the light beam thereby causing the light-absorbing layer to be heated, wherein the heated light-absorbing layer is in thermal contact with the melt layer for conducting its heat to the melt layer thereby causing a temperature of the melt layer to rise above its melting temperature, wherein the light-absorbing layer has a melting temperature which is higher than the melting temperature of the melt layer such that the light-absorbing layer can remain solid while the melt layer is melted by the heat conducted from the light-absorbing layer, and the cover layer 25 of the photocurable adhesive composition 26 covering the melt layer 23.

As indicated in FIG 4B, during a release, light L passed thorough the carrier substrate 21 and heats up light-absorbing layer 24. Heat is transferred from the light-absorbing layer 24 to the underlying melt layer 23. Upon the melting of the layer 23 adhesion to the cover layer 25 and the die associated thereto is degraded, e.g. due to dewetting between the cover layer 25 and molten droplets 23' of the melt layer 23. As a result the die 1 can be released, e.g. under the influence of gravity, onto a bond area 1001 of the circuit board 1000. Remnants of the cover layer 25 associated to the transferred die can be removed using standard methods.

In a variation the melt layer comprises a first metal layer.

In another or further variation the light-absorbing layer comprises a second metal layer.

It will be appreciated that the die or dies to be released can be selected and transferred individually (or as a sub set or the entire set) by selective illumination, e.g. by illumination individual dies or series of dies sequentially using a focused beam. By using wide area illumination multiple dies be released concurrently.

In another or yet further variation the cover layer 25 comprises a polymer based adhesive, e.g. a negative photo resist.

In still other or further variations the cover layer the light-absorbing layer has a higher surface energy per unit area than the adhesive layer, wherein, upon melting of a melt layer in the release stack of a selected die/component, the melt layer predominantly sticks to the light-absorbing layer of the release stack while the adhesive cover layer 25 predominantly sticks to the selected die/component 1, wherein the adhesive layer can be transferred to a target 1000 with the selected die while the melt layer predominantly remains with part of the release stack.

In still yet other or further variations the light beam L2 illuminating the release stack is configured to cause a temperature of the melt layer to rise above its melting temperature but remain below its evaporation temperature.

Preferably, the cover layer has a disintegration temperature that is above the melting temperature of the melt layer, or higher than three hundred degrees Kelvin below the melting temperature of the melt layer.

Preferably, the melting temperature of the melt layer is less than six hundred degrees Kelvin, wherein the melting temperature of the light-absorbing layer is higher than the melting temperature of the melt layer by at least one hundred degrees Kelvin.

For examples of suitable compositions of the melt layer 23 and the light-absorbing layer 24 reference is made to WO2022/186689.

Preferably, the process of photo induced release of one or more dies is preceded by patterning the one or more of the layers in the release stacks so as to segregate the dies. Segregating the dies advantageously mitigates lateral adhesion between dies, especially via the cured adhesive cover layer.

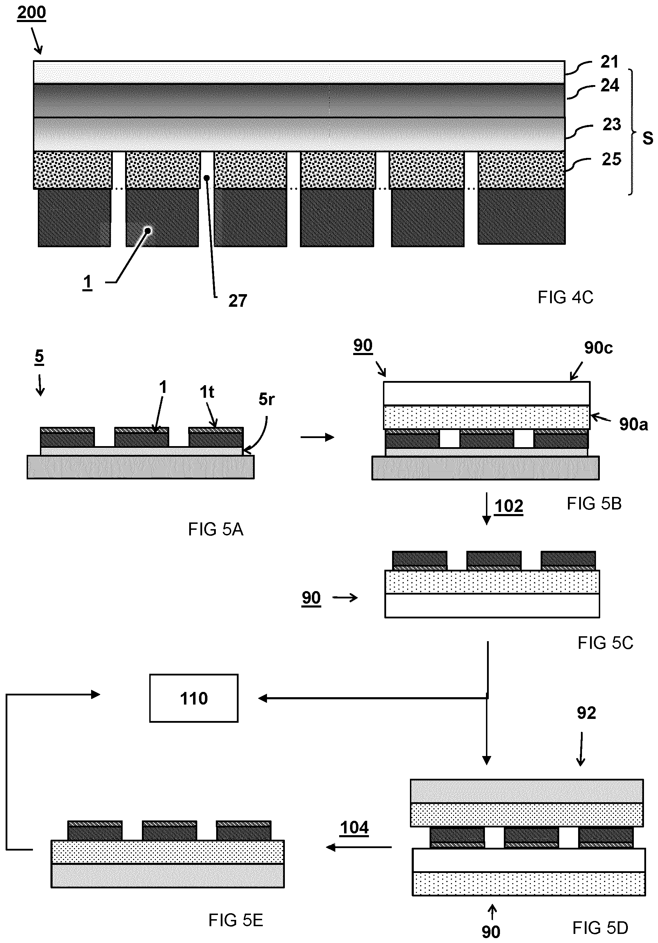

FIG 4C illustrates a loaded die transfer carrier 200 wherein the dies have been segregated by removing portions 27 of layer 25 between adjacent dies, e.g. by etching. The removed portions can coincide with the previously photo cured areas but need not necessarily coincide. Removal of extra material (under partial etching) or less (e.g. by focused ion beam) is also foreseen. Of course corresponding zones of one or more of the melt layer 23 and light-absorbing layer 24 can also be removed to further segregate the dies. Inventors found that local removal of layer 25 suffices to mitigate adverse effects on transfer fidelity by lateral adhesion.

In a variation as the method comprises one prior transfer process of dies/components from a source for from a suitable donor substrate.

In another or further variation method comprises two (or more) prior transfer process of dies/components from a source to form a suitable donor substrate.

A single prior transfer process can be particularly relevant if the components/dies are suppled on a carrier which is insufficiently transparent to allow the photocuring process as disclosed herein. For example, when the dies/components are supplied on a so called epi-wafer. Alternatively, or in addition, the single prior transfer process can be of particular relevance if a die flip is foreseen (e.g. in case the die on an original source are formed or provided wrong side up.

When the dies are in the correct orientation (and when the transfer carrier is selected to be sufficiently UV transparent) the formed stack can be used directly as the donor substrate (cf. stage 110 in FIG 1).

FIG 5 illustrates a method comprising one or more intermediate transfer stages. FIG 4A illustrates a plurality of dies 1 formed on an EPI wafer. For illustration purposed the die on native substrate 5 (Epi wafer) are held by a common release layer 5r. To keep track of die orientation top sides 5t of the dies are marked. In a next step a first intermediate transfer carrier 90 (e.g. thermal release tape) is positioned on top of the dies. A stack formed with (in order top to bottom) a carrier 90c of the transfer tape, the adhesive of the transfer tape 90a and the dies, whereby the adhesive 90a contacts the tops of the dies (FIG 2B). Upon removal of the native carrier the dies are transferred 102 to the tape (FIG 5C). From there transfer tape may be used as donor in the method of redistributing singulated dies. Alternatively, e.g. incase a further transfer is desired (e.g. to reorient the components), the process can be continued by a subsequent transferring 104 of the dies from the first intermediate transfer carrier 90 to a second intermediate transfer carrier 92 thereby flipping the dies and forming the donor substrate. To transfer the components a second intermediate transfer carrier 92 is positioned onto the source forming a stack with the top of components contacting the adhesive layer (see FIGs 5D and 5E). When the adhesion (z) of the second intermediate carrier exceeds the adhesion (y) removal of the first substrate 90 results in transferring 104 the dies to the second intermediate carrier. Note that the orientation of the dies is hereby flipped again (as indicated in FIG 5E). It will be understood that the prior transfer process can include further one of the transfer/flipping stages as discussed herein.

Similar as described herein above the prior transfer processes 102, 104 can include a step of reducing an adhesion between the singulated dies and the current carrier prior to peeling off the respective carrier (e.g. by UV exposure in case of a UV transfer tape or a thermal treatment in case of a thermal transfer tape.

Inventors found that a practical working configuration for a dual prior transfer procedure can involve the use of a UV transfer tape as the first intermediate carrier substrate and a thermal transfer tape as the second intermediate carrier substrate.

It will be appreciated that the release temperature of the last intermediate transfer substrate is preferably above a soft bake temperature and below a hard bake temperature of the photocurable adhesive. Preferably, the release temperature of the donor substrate overlaps (most preferably with ± degrees C) with the hard bake temperature. In this way relative positions of the dies are fixed by at least one adhesive during the redistributing from the donor to the acceptor.

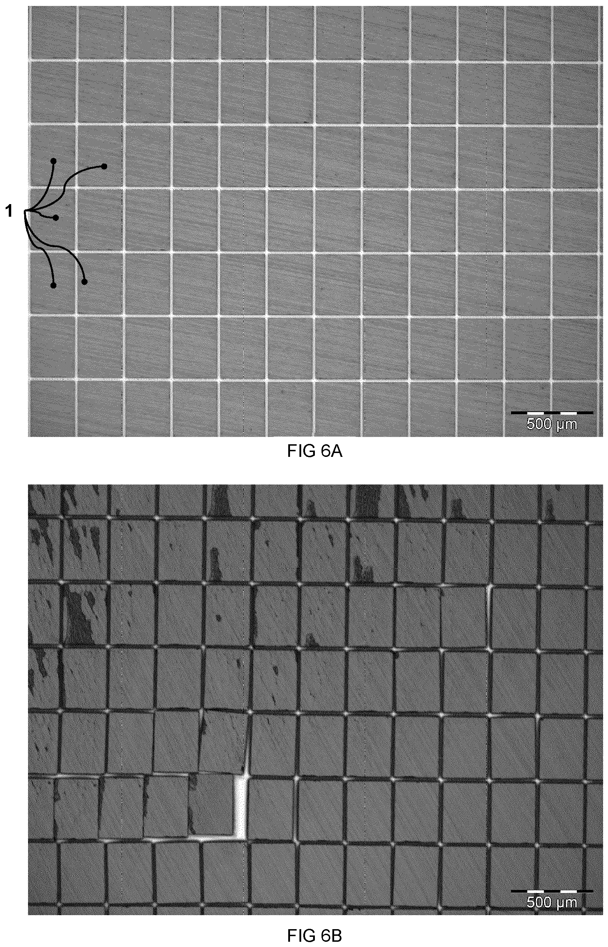

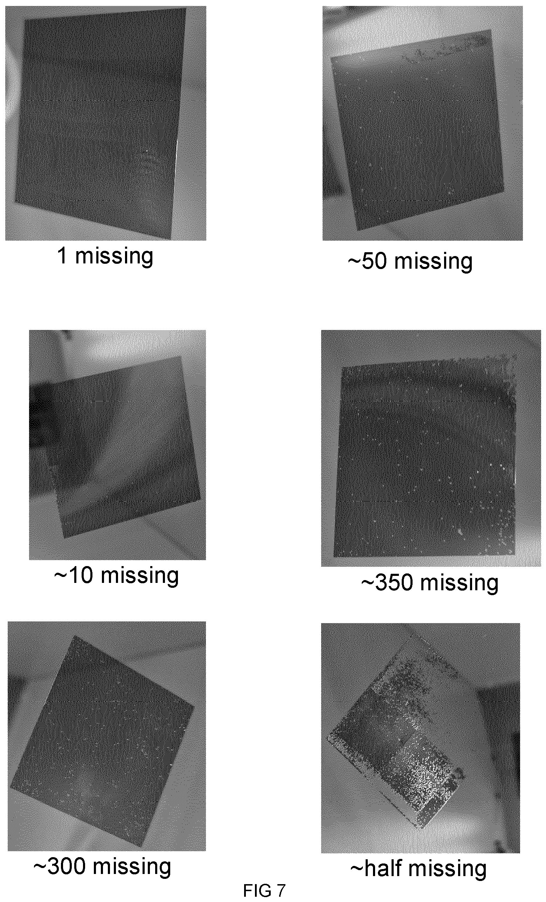

FIGs 6 and 7, provide experimental details.

FIGs 6A and 6B illustrates experimental details, wherein FIG 6A provides a micrograph (scalebar 500 pm) displaying part of an array of dies transferred from a donor to an acceptor according to the method as disclosed herein, i.e. with photo curing spacings between adjacent dies 1, whereas FIG 6B provides a comparative example without photo curing spacings between adjacent dies. As can be seen the dies transferred according to the disclosed method retain a regular array, whereas without photocuring transfer is less precise.

FIG 7 illustrates a series of loaded die transfer carriers. For each carrier the source (an epi wafer) comprises >50000 dies in a regular array. The carriers have been manufactured in a variation of the process comprising two intermediated die transfers (source - intermediate 1 - intermediate 2 - target). Intermediate carrier 1 was a commercial UV transfer tape, intermediate carrier 2 was a commercial thermal transfer tape - both having a high adhesion. For each carrier the cover layer photocurable adhesive composition has been photocured prior to final transfer from the second intermediate carrier.

The carriers depicted differ in the extent at which the initial adhesion of the UV transfer tape and the thermal transfer tape was reduced prior to transfer. For the top left sample the adhesion of the UV and thermal tape was reduced to below an initial tack of the receiving substrate. For the remaining samples the degree of reduction was progressively less. The amount of dies usefully transferred correlates with the level of adhesion reduction from only 1 die mission (from >50000) to -half the dies missing without prior reduction of adhesion.

For the purpose of clarity and a concise description, features are described herein as part of the same or separate embodiments, however, it will be appreciated that the scope of the invention may include embodiments having combinations of all or some of the features described. For example, while embodiments were shown for loading an intermediate die transfer carrier 200, also alternative ways may be envisaged by those skilled in the art having the benefit of the present disclosure for achieving a similar function and result. Of course, it is to be appreciated that any one of the above embodiments or processes may be combined with one or more other embodiments or processes to provide even further improvements in finding and matching designs and advantages. It is appreciated that this disclosure offers particular advantages to manufacturing of devices benefitting from the provide high fidelity in transfer of individualized dies, such as microLED displays, and in general can be applied for any application having a high density microelectronic components (dies).

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

## Claims

1. A method (100) of redistributing singulated dies (1), the method comprising:
i) providing (110) a donor substrate (10)] supporting an array (A) of said dies, and providing (111) an acceptor substrate (20) comprising a carrier substrate (21) with a cover layer (25) of a photocurable adhesive composition (26);
ii) assembling (120) the donor substrate (10) onto the acceptor substrate forming a stack (30) having the singulated dies sandwiched between the dicing foil and the cover layer of the photocurable adhesive composition;
iii)photocuring (130) the photocurable adhesive composition at spacing (2) between adjacent ones of the singulated dies by providing a photonic exposure (PE) from a backside (31) of the donor substrate opposite the dies ;
iv) developing (140) the cover layer of the photocurable adhesive composition by thermal exposure; and
v) releasing (150) the donor substrate from the stack.

2. The method according to claim 1, further comprising prior to i)
providing (100) a native substrate (5) supporting the dies in the array,
transferring (102) the dies to a first intermediate transfer carrier (90) thereby flipping the dies and forming the donor substrate.

3. The method according to claim 1, further comprising prior to i)
providing (100) a native substrate (5) supporting the dies in the array,
transferring (102) the dies to a first intermediate transfer carrier (90) having a thereby flipping the dies
transferring (104) the dies to from the first intermediate transfer carrier (90) to a second intermediate transfer carrier (92) thereby flipping the dies and forming the donor substrate.

4. The method according to claim any of the preceding claims, wherein the releasing (150) the donor substrate is performed during the process of developing (140) the photocurable adhesive composition.

5. The method according to claim 1 or 2, further comprising:
soft baking (115) the cover layer of the photocurable adhesive composition prior to the assembling (120).

6. The method according to any of the preceding claims, further comprising
reducing (112) an adhesion between the singulated dies and the donor substrate by exposing the donor to a thermal and/or a UV exposure prior to and/or during the assembling.

7. The method according to any of the preceding claims, wherein the acceptor 20 comprises a release stack (S) disposed onto the carrier substrate (21) for releasing one or more of the dies as transferred thereon to a target substrate (90) following an illumination of the release stack by a light beam (L) through the carrier substrate (21), wherein the release stack comprises
a melt layer (23) having a melting temperature (Tm23),
a light-absorbing layer (24) disposed between the carrier substrate and the melt layer, wherein the light-absorbing layer has an absorption coefficient for absorbing the light beam thereby causing the light-absorbing layer to be heated, wherein the heated light-absorbing layer is in thermal contact with the melt layer for conducting its heat to the melt layer thereby causing a temperature of the melt layer to rise above its melting temperature, wherein the light-absorbing layer has a melting temperature which is higher than the melting temperature of the melt layer such that the light-absorbing layer can remain solid while the melt layer is melted by the heat conducted from the light-absorbing layer, and
the cover layer (25) of the photocurable adhesive composition (26) covering the melt layer (23), wherein
a temperature during transferring the array of singulated dies from the donor to the acceptor remains below the melting temperature of the melt layer (23).

8. The method according to any of the preceding claims, wherein the photocurable adhesive composition (26) comprises a negative photo resist.

9. The method according to any of the preceding claims, wherein the photocurable adhesive composition (26) is an epoxy based negative photo resist.

10. The method according to any of the preceding claims, wherein the photocurable adhesive composition (26) comprises SU8.

11. Loaded die transfer carrier (200), comprising a carrier substrate (21) having a cover layer (25) formed of a photocurable adhesive composition (26) and an array (A) of singulated dies (1), wherein
first portions of the photocurable adhesive composition (26) corresponding to areas underlying dicing streets (2) between adjacent ones of the singulated dies (1) are photocured (26c).

12. The die transfer carrier according to claim 11, wherein the carrier substrate (20) comprises a transparent carrier (21), and a release stack (S) disposed onto the carrier for releasing one or more of the dies as supported thereon to a target substrate (90) following an illumination of the release stack by a light beam (L) through the transparent carrier, wherein the release stack comprises
a melt layer (23) having a melting temperature (Tm23),
a light-absorbing layer (24) disposed between the transparent carrier and the melt layer), wherein the light-absorbing layer has an absorption coefficient for absorbing the light beam thereby causing the light-absorbing layer to be heated, [[ wherein the heated light-absorbing layer is in thermal contact with the melt layer for conducting its heat to the melt layer thereby causing a temperature of the melt layer to rise above its melting temperature (Tm13)]], wherein the light-absorbing layer has a melting temperature (Tm24) which is higher than the melting temperature of the melt layer such that the light-absorbing layer can remain solid while the melt layer is melted by the heat conducted from the light-absorbing layer, and
the cover layer (25) covering the melt layer (23).

13. The die transfer carrier according to any of the preceding claims 11 - 12, wherein the photocurable adhesive composition (26) is an epoxy based negative photo resist, preferably wherein the photocurable adhesive composition (26) comprises SU8.

14. The method or the die transfer carrier according to any of the preceding claims, wherein the dies are microLED semi-conductor elements.

15. Use of the method or the die transfer carrier according to any of the preceding claims in the manufacturing of a microelectronic device, such as microLED display, the use comprising redistributing one or more of the dies as transferred onto the cover layer 25 of the carrier substrate 21 to a target location on product carrier.
